# EUROPÄISCHE PATENTSCHRIFT

(11) **EP 2 517 265 B1**
(45) Veröffentlichungstag und Bekanntmachung des Hinweises auf die Patenterteilung: **08.11.2017**
(21) Anmeldenummer: 10803242.6
(22) Anmeldetag: 23.12.2010
(51) Int. Cl.: H01L 31/02, H01L 31/05, H02S 40/34

(54) **SOLAR-MODUL MIT EINER LEITERPLATTE UND VERFAHREN ZUR HERSTELLUNG UND ANWENDUNG**
SOLAR PANEL COMPRISING A PRINTED CIRCUIT AND METHOD OF PRODUCTION AND USE THEREOF
MODULE SOLAIRE DOTÉ D'UNE CARTE DE CIRCUIT IMPRIMÉ, PROCÉDÉ DE FABRICATION ET UTILISATION

(30) Priorität: 23.12.2009 DE 102009060604
(43) Veröffentlichungstag der Anmeldung: 31.10.2012
(73) Patentinhaber: Energetica Holding GmbH, 9073 Klagenfurt-Viktring (AT)
(72) Erfinder: BATTISTUTTI, René, 9020 Klagenfurt (AT)
(74) Vertreter: Riebling, Peter
(86) Internationale Anmeldenummer: PCT/EP2010/007910
(87) Internationale Veröffentlichungsnummer: WO 2011/076418

(56) Entgegenhaltungen:
- EP-A1- 0 373 233
- EP-A1- 2 109 150
- EP-A2- 1 469 527
- DE-A1-102007 032 603

## Beschreibung

Gegenstand der Erfindung ist ein Solarmodul, bestehend aus einer Mehrzahl von Solarzellenketten, die wiederum aus einer Mehrzahl von in Serie geschalteten Solarzellen bestehen, wobei die Solarzellenketten in Serie und/oder parallel geschaltete sein können und mittels Haftverbundfolien bzw. aufextrudierten Materialien zwischen einem vorderseitigen Glassubstrat und einer rückseitigen Folie beziehungsweise einem rückseitigen Glassubstrat bzw. einer vorderseitigen Folie und einer rückseitigen Trägerplatte (Kunststoff, Glas oder Metall) einlaminiert sind.

Solarzellen werden einzeln oder zu Gruppen beziehungsweise Solarzellenketten zu einem Solarmodul verschaltet in Photovoltaikanlagen beziehungsweise in stromnetzunabhängigen Verbrauchern oder zur Stromversorgung verwendet.

Ein Solarmodul wird durch seine elektrischen Anschlusswerte (z. B. Leerlaufspannung und Kurzschlussstrom) charakterisiert. Diese hängen von den Eigenschaften der einzelnen Solarzellen und der Verschaltung der Solarzellen innerhalb des Moduls ab. Um den Anforderungen einer Anlage für solar erzeugten Strom gerecht zu werden, fasst man Solarzellen mittels mehrerer verschiedener Materialien zu einem Solarmodul zusammen. Dieser Verbund erfüllt folgende Zwecke:
- transparente, strahlungs- und witterungsbeständige Abdeckung
- robuste elektrische Anschlüsse
- Schutz der spröden Solarzelle vor mechanischen Einflüssen
- Schutz der Solarzellen und elektrischen Verbindungen vor Feuchtigkeit
- Berührungsschutz der elektrisch leitenden Bauteile
- Handhabungs- und Befestigungsmöglichkeit

Es gibt verschiedene Bauformen von Solarmodulen mit verschiedenen Arten von Solarzellen. Im Folgenden wird anhand des weltweit am häufigsten eingesetzten Modultyps der Aufbau erklärt:
- Eine Glasscheibe (meist sogenanntes Einscheiben-Sicherheits-Glas, kurz ESG aus Solarglas, also eisenoxidarmen Glas) auf der zur Sonne gewandten Seite bzw. eine Kunststoffscheibe aus Polycarbonat (PC) oder Polymethylmetacrylat (PMMA) und dergleichen hochtransparente und schlagzähe Scheibenmaterialien.
- Eine transparente Kunststoffschicht (Ethylenvinylacetat (EVA) oder Polyvinylbutyral (PVB) oder EVM-Kautschuk Levamelt von Lanxess) oder Silikon (z.B. Dow Corning) in der die Solarzellen eingebettet sind.
- mono- oder polykristalline Solarzellen oder amorphe oder organische Solarzellen beziehungsweise starre oder flexible Solarzellen oder allgemein Dünnfilm-Solarzellen oder Solarzellen aus partikulären halbleitenden Partikeln , die durch Lötbändchen elektrisch miteinander verschaltet sind,
- Rückseitenkaschierung mit einer witterungsfesten Kunststoffverbundfolie z. B. aus Polyvinylfluorid (Tedlar) sowie PA Bsp. AAA von Isovolta und Polyester, beispielsweise Icosolar von Isovolta oder aber einem Rückseitenglas aus ESG-Floatglas oder aus einer transparenten Kunststoffschicht beziehungsweise Folie oder aus einer Metallplatte beziehungsweise Metallfolie oder aus einer Kunststoffplatte,
- Anschlussdose mit Freilaufdiode bzw. Bypassdiode und Anschlussterminal ,
- ein Aluminiumprofil-Rahmen zum Schutz der Glasscheibe bei Transport, Handhabung und Montage, für die Befestigung und für die Versteifung des Verbundes beziehungsweise bei speziellen Anwendungen auch rahmenlos.

In der EP0499075B1 wird ein Solarzellenstring vorgeschlagen, bei dem zueinander beabstandete Solarzellen über Kontaktelemente in Reihe geschaltet werden, die eine Relativbewegung zwischen den Zellen ermöglichen.

In der EP 1018166 B1 wird eine allgemein übliche Methode der Herstellung und Lamination von Photovoltaik-Modulen genannt. Dabei werden in Serie beziehungsweise parallel geschaltete Solarzellen beidseitig mit einem Einkapselungsmaterial, beispielsweise und üblicherweise EVA (Ethylenvinylacetat), in einer Laminieranlage gemeinsam mit einem Frontglas und einer rückseitigen Einkapselungsfolie zusammen laminiert.

In der WO 2009/092111A2 wird ein Photovoltaikmodul genannt, das eine Mehrzahl an Photovoltaik-Zellen beinhaltet, die mit einer leitfähigen Rückseitenfolie elektrisch verbunden werden, wobei eine nicht leitfähige Folie zwischen den Zellen und der leitfähigen Rückseitenfolie angeordnet ist.

In den Schriften DE 102008032990 A1 und EP1045455 B1 wird das Problem der Beschattung einzelner Zellen in einer Serienschaltung beziehungsweise Parallelschaltung genannt und es werden Lösungen durch Beschaltung mit elektronischen Bauteilen genannt. In beiden Fällen wird keine Integration dieser zusätzlichen elektronischen Komponenten im Solarzellen-Laminatverbund mittels mindestens einer Leiterplatte genannt.

In der Druckschrift Solarc DE 10261876 B4 Herstellverfahren für Solarmodule mittels Leitkleber-Bonding und Solarmodule mit Leitkleberbrücken wird ein Standard-String-Prozeß verwendet, bei dem elektrisch leitfähige und lötbare Bändchen oben und unten auf einer Leiterplatte festgelegt werden. Damit werden die Solarzellen in Serie geschalte und an den Enden werden die Strings mit Kontaktflächen und einem Leitkleber kontaktiert.

Allerdings weisen Leitkleber einen wesentlich höheren Übergangswiderstand auf und dadurch müssen dann die Kontaktflächen rel. groß ausgebildet werden. In dieser Solarc-Erfindung wird ein großflächiger elektrisch isolierender Trägerkörper als Leiterplatte benannt und darauf werden die Zellen kontaktiert.

Die DE 10 2007 032603 A1 offenbart ein Solarmodul bestehend aus einer Mehrzahl von Solarzellenketten, die zwischen einem vorderseitigen Glassubstrat und einer rückseitigen Folie einlaminiert sind. Die Verdrahtung der Solarzellenketten erfolgt über eine Leiterplatte, die randseitig im Laminatverbund angeordnet ist. Die Photovoltaik Modulanschlüsse sind rückseitig durch eine Aussparung in der rückseitigen Folie angeordnet. Ein Solarmodul mit ähnlichem Aufbau ist in der EP 2 109 150 A1 beschrieben.

Beim dem vorher genannten Stand der Technik besteht der Nachteil einer aufwändigen Montage und Verdrahtung.

Der Erfindung liegt deshalb die Aufgabe zugrunde, eine Mehrzahl von Solarzellen so zu verbinden, beziehungsweise zu kontaktieren, dass eine kostengünstigere Montage und gleichzeitig eine hohe Flexibilität bezüglich der Serienschaltung und Parallelschaltung und der Integration von elektronischen Bauteilen, insbesondere Bypassdioden, gegeben ist und derart ein sicherer Betrieb auch bei Teilabschattungen einzelner Solarzellen möglich ist, beziehungsweise ein Betrieb beim oder möglichst nahe beim maximalen Leistungspunkt (MPP= Maximum Power Point) gewährleistet ist.

Zur Lösung der gestellten Aufgabe ist die Erfindung durch die technische Lehre des Anspruches 1 gekennzeichnet.

Wesentliches Merkmal der Erfindung ist, dass die Verdrahtung von zumindest den Solarzellenketten über zumindest eine streifenförmige Leiterplatte erfolgt. Diese zumindest eine Leiterplatte ist Modul-randseitig in der Ebene der Solarzellen im Laminatverbund angeordnet.

Weil sie nur streifenförmig mit geringer Fläche ausgebildet ist, benötigt sie im Laminatverbund nur randseitig Platz. Der Vorteil dabei ist, dass durch die leiterplattenseitige Verdrahtung die Stabilität, Lebensdauer und Qualität des Solarmoduls erhöht wird.
Damit können die einzelnen Strings einfach zusammengelötet werden und lediglich ein einziger Anschluss muss nach außen abgeführt werden.

Die Solarmodulanschlüsse werden von dieser Leiterplatte rückseitig oder seitlich an den Randstellen des Moduls durch eine Aussparung in der rückseitigen Folie beziehungsweise dem rückseitigen Glassubstrat ausgebindet.

Im Gegensatz zur der Solararc-Druckschrift werden die erfindungsgemäß vorgesehenen Leiterplatten nicht als Trägerkörper für die Solarmodule ausgebildet und sind nicht unterhalb der Solarzellen vorgesehen, sondern lateral oben und/oder unten und/oder seitlich, also in der gleichen Ebene, wie die Solarzellen in deren Laminatverbund randseitig integriert. Dadurch kann die Leiterplatte dünn ausgebildet werden (typisch 0,8 mm bis etwa 0,2 mm Dicke), weil sie nur der Kontaktierung der Strings dient und keine tragende Funktion hat.

Weiters wird ein Verfahren zur Herstellung eines Solarmoduls genannt, wobei die Leiterplattenanschlüsse mit den Solarzellen beziehungsweise den Solarzellenketten elektrisch verbunden werden und auf der Ebene der Solarzellen mittels Haftverbundfolien zwischen einem vorderseitigen Glassubstrat und einer rückseitigen Folie beziehungsweise einem rückseitigen Glassubstrat mit einer Laminiervorrichtung zusammenlaminiert werden und der Anschluss rückseitig mit direkten Kontakten zur Leiterplatte erfolgt und es wird die Anwendung zur direkten Konvertierung von Sonnenenergie in elektrische Energie beschrieben.

Erfindungsgemäß werden mono- oder multi-kristalline Module, also c-Si Zellen, verwendet. Vorteilhaft haben c-Si Zellen Abmessungen von beispielsweise 200 x 200 mm bis etwa 103 x 103 mm.

Neben der Verwendung von mono- oder multikristalline Solarzellen können Dünnfilmzellen oder flexible organische Photovoltaikzellen oder flexible anorganische Photovoltaikzellen oder rückseitig kontaktierte Solarzellen verwendet werden. Diese sind in Serie geschaltet und einzelne Zellen-Ketten können ebenfalls in Serie oder parallel geschaltet und deren Anschlüsse zu einem Modulanschluß zusammengeführt werden. Es werden diverse elektronische Komponenten, insbesondere Bypassdioden, Schaltelemente oder MPP-Tracking Bauelemente mit verschaltet. Die Art der Serien- und Parallelschaltung kann dabei nach dem Stand der Technik gewählt werden und die Anzahl dieser Verbindungsbänder, insbesondere der sogenannten Strings, also bandförmiger elektrisch leitfähiger Verbindungsleiter, kann ebenfalls nach dem Stand der Technik gewählt werden.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.

Im Folgenden wird die Erfindung anhand von mehrere Ausführungswege darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: perspektivische Darstellung von zwei über Strings (5) miteinander verschalteten Solarzellen (2, 2), die aus einer Mehrzahl von Einzelzellen (3) bestehen,
- Figur 2:: einen schematischen Schnitt durch ein Solarmodullaminat (6, 8, 5, 2, 9, 7),
- Figur 3:: eine schematische Draufsicht auf ein Solarmodul (1) mit einer Leiterplatte (10),
- Figur 4:: eine schematische Draufsicht auf ein Solarmodul (1) mit vier Leiterplatten (11, 12, 13, 14),
- Figur 5:: einen schematischen Schnitt durch ein Solarmodullaminat (6, 8, 5, 2, 9, 7) mit einer Leiterplatte (11).
- Figur 6:: Die Draufsicht auf ein Modul mit 60 Zellen
- Fig. 7:: Schnitt gem. der Linie A-B in Fig. 6
- Fig. 8:: Draufsicht auf den Anschluss der Strings an die Leiterplatte vor dem Einlaminieren
- Fig. 9: die Leitungsführung 24 in der Anschluß-Box 19 mit einer Serien-Parallelschaltung von Bypassdioden 23
- Fig. 10: schematische Darstellung des oberen Bereichs eines Solarmoduls 1

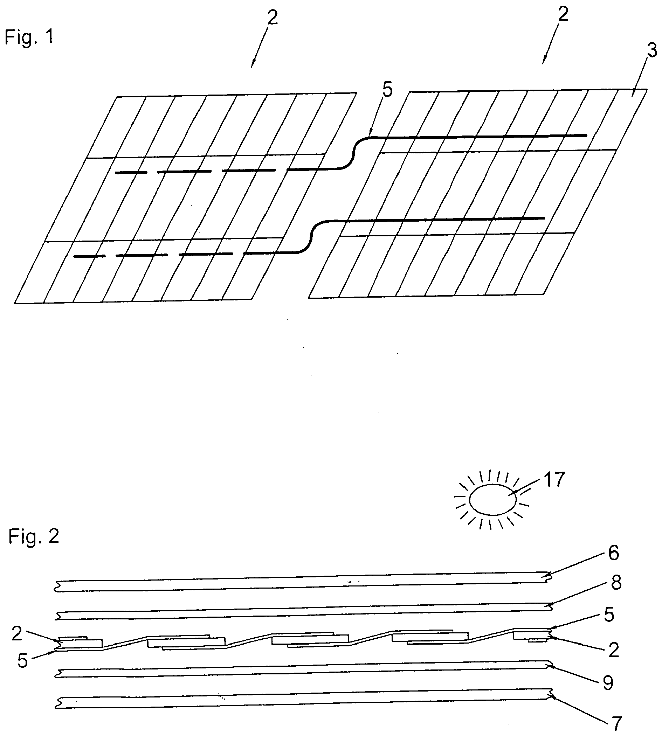

In **Figur 1** ist eine perspektivische Darstellung von zwei über Strings (5) miteinander in Serie verschalteten Solarzellen (2, 2) die aus einer Mehrzahl von Einzelzellen (3) bestehen, dargestellt. Die Anzahl der Strings (5) pro Zelle (2) kann variieren. Zwei Strings (5) nebeneinander sind jedoch eine weit verbreitete Ausführungsform.

In **Figur 2** wird ein schematischer Schnitt durch ein Solarmodullaminat (6, 8, 5, 2, 9, 7) dargestellt. Die einzelnen Solarzellen (2) sind üblicherweise mit einigen Millimetern beabstandet in einer Ebene angeordnet und die Strings (5), also verzinnte und damit gut lötbare Kupferstreifen, werden auf der Unterseite einer Zelle (2) elektrisch leitend kontaktiert und dann mit der Oberseite einer nachfolgend angeordneten Zelle (2) verbunden. Die elektrische Kontaktierung kann durch Löten mit einem auf Löttemperatur geheizten Lötelement erfolgen oder mit einer Flamme oder einem Laser oder Induktion oder Licht, wobei üblicherweise noch Lötzinn zugeführt wird.

Ebenso kann die elektrische Verbindung durch einen hochleitfähigen Leitkleber erfolgen. Die elektrisch leitfähigen Kontakte können flächig oder linienförmig oder punktartig ausgeführt werden.

Das Kontaktmaterial, das auf der Leiterplatte durch den Leitkleber kontaktiert wird, muss nicht nur aus Silber oder Aluminium sein, sondern kann auch aus anderen elektrisch gut leitenden, aber nicht unbedingt lötfähigen Materialien, wie zum Beispiel leitfähigen Oxidoberflächen, oder aus nicht drahtbond-fähigen Materialien, wie z.B. Zinn-Blei-Legierungen oder bestimmte im Siebdruckverfahren hergestellte Kontaktschichten bestehen. Deshalb können die Rückkontakte der Solarzellen mittels einer gedruckten oder dispensten Leitkleberschicht mit den entsprechenden Leiterbahnabschnitten der Leiterplatte verbunden werden.

Die zur Sonne (17) zugewandte Frontscheibe (6) wird üblicherweise aus einem eisenoxidarmen Solarglas als üblicherweise teilvorgespanntes oder Einscheibensicherheitsglas (ESG) und selten aus Floatglas gefertigt. Als Dicke wird üblicherweise 3,2 mm und 4 mm verwendet, da Glas schwer ist und derart das Gesamtgewicht gering gehalten werden kann. Für spezielle Anwendungen, wie Dachelemente oder Vordächer oder Brüstungselemente werden jedoch auch Verbundsicherheitsglas (VSG) Scheiben verwendet.

Weiters werden oftmals entspiegelte Glasscheiben (6) verwendet, wobei nur die Ebene 1, also die der Sonne (17) zugewandte Seite entspiegelt ausgeführt werden muß, da die innere Seite (Ebene 2) durch das Laminat (8) keine hohen Reflektionen an deren Verbindungsebene aufweist. Die Entspiegelung kann mittles optisch dünner Mehrfachschichten mit unterschiedlichen Brechungsindices oder mit einer einzigen dünnen Schicht mit einem verlaufenden Brechungsindex erreicht werden, wobei Vakummabscheideverfahren oder Solgel-Beschichtungsverfahren eingesetzt werden können. Eine kostengünstige Variante besteht noch in der Verwendung von vorderseitig prismierten oder allgemein strukturierten Pressgläsern.

Die frontseitige und rückseitige Verbundfolie (8, 9) kann aus den transparenten Kunststoffmaterialien Ethylenvinylacetat (EVA) oder Polyvinylbutyral (PVB) oder EVM-Kautschuk Levamelt von Lanxess oder Silikon von Dow Corning oder anderen Einkapselungsmaterialien nach dem Stand der Technik gewählt werden. Dabei werden üblicherweise etwa 370 µm beziehungsweise 430 µm dicke Folien verwendet beziehunsgweise mehrere Folien oder auch doppelt so dicke Folien.

Als Rückseitensubstrat kann eine witterungsfeste Kunststoffverbundfolie z. B. aus Polyvinylfluorid (Tedlar) und Polyester oder PA (z.B. AAA von Isovolta) mit und ohne einer anorganischen Wasserdampfsperrschicht, beispielsweise Icosolar von Isovolta oder aber einem Rückseitenglas aus ESG-Floatglas mit beispielsweise 3,2 mm Dicke oder 4 mm Dicke oder größeren Dicken beziehungsweise auch einer VSG-Glasscheibe verwendet werden.

Die Lamination dieser Elemente (6, 8, 5, 2, 9, 7) erfolgt in einem Laminator mittels Druck und Temperatur, bevorzugt wird noch ein Vakuum eingesetzt.

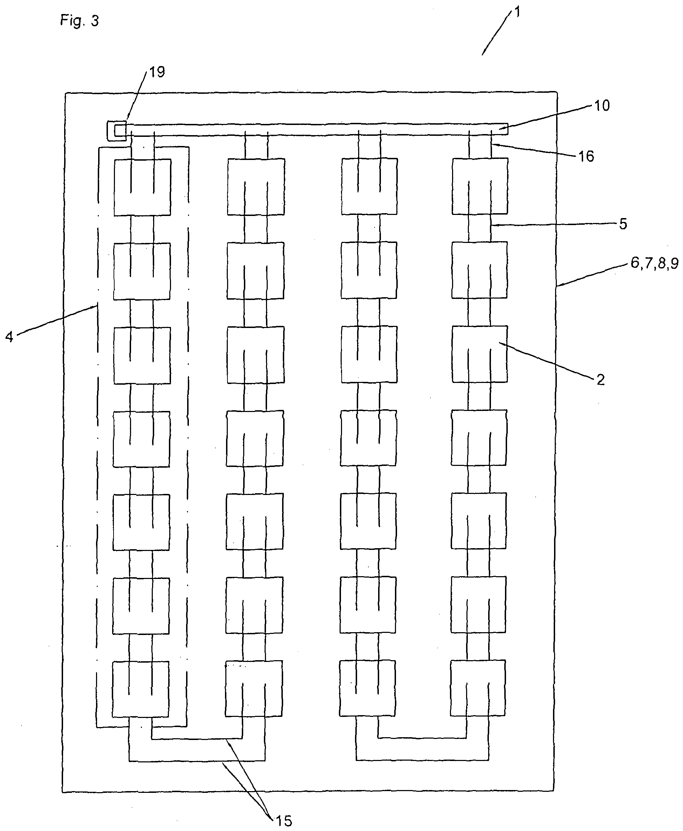

In **Figur 3** wird eine schematische Draufsicht auf ein Solarmodul (1) mit einer Leiterplatte (10) dargestellt. In dieser Ausführungsform wird ein Leiterplattenstreifen (10) an der oberen Kante des Solarmoduls (1) angeordnet und es werden die Kontaktstellen auf der Leiterplatte (10) in Kupfer-Lötzinn (Hot-air-levelling oder chemisch Zinn) oder in Kupfer-Nickel-Gold oder in Kupfer-Silber ausgebildet und es können derart Anschlußelemente (16) als auch allfällige elektronische Bauteile (nicht gezeichnet), insbesondere Bypassdioden, Schaltelemente oder MPP-Tracking Bauelemente und dergleichen elektronische Elemente, bevorzugt in SMD (Surface Mount Devices) Ausführung beziehungsweise in SMT (Surface Mount Technology) Technik, mittels Löten oder Ultraschall oder Laser-induziert kontaktiert werden, wobei die elektronischen Bauteile bereits bestückt auf der Leiterplatte (10) verwendet werden können.

In dieser in Figur 3 dargestellten Variante werden je zwei Solarzellenketten (4) mit den Verbindungs-Strings (15) in Serie geschaltet und mittels der Verbindungselemente (16) mit der Leiterplatte verbunden. Grundsätzlich kann jedoch jede einzelne Zelle (2) mit der Leiterplatte (10) verbunden werden und derart optimal mit elektronischen Bauteilen auf der Leiterplatte (10) geschaltet oder betrieben werden (MPP-Tracking) werden.

Dabei kann eine Leistungsminderung durch Abschattung oder Defekt einer oder mehrerer Einzelzellen (3) oder Zellen (2) durch elektronische Maßnahmen derart gelöst werden, dass das Solarmodul (1) immer im MPP (Maximum Power Point), also im maximalen Leistungsbereich, betrieben wird (Dies bedeutet ein auf der Leiterplatte integriertes MPP Tracking).

Die Leiterplatte (10) kann als einseitige, durchkontaktierte oder mehrlagige Leiterplatte ausgebildet sein und es können Materialien wie FR-2, FR-4 oder CEM-1 oder auch FPC (Flexible-Printed-Circuit)-Materialien beziehungsweise nahezu alle in der Leiterplattenindustrie üblichen Materialien verwendet werden. Die Lötstopmaske, also die Farbe der Leiterplattenoberfläche, kann beliebig farbig ausgeführt werden. Insbesondere eine weiße Oberfläche ist von Interesse, da eine geringe Sonnenabsorption gegeben ist und damit eine geringe Erwärmung erreicht wird.

Weiters können auf der Leiterplattenoberfläche Informationen mittels Drucktechniken wie Siebdruck oder InkJet-Druck oder Tampondruck oder Transferdruck oder Laserdruck angeordnet werden.

Es können dabei visuell und/oder maschinell lesbare Informationen (z.B. drahtlos auslesbar durch RFID-Module) angeordnet werden. Insbesondere kann ein Barcode, eine Herstellerangabe, eine Typenangabe, eine Produktionsdatumsangabe beziehungsweise diverse Logos und Zulassungskennzeichnungen angeordnet sein.

Die Leiterplatte (10) kann mit elektronischen Bauteilen bestückt werden und es kann eine elektronische Schaltung hergestellt werden, die eine Diebstahlsicherung ermöglicht und insbesondere einen Code zur Freigabe des Solarmoduls (1) beinhaltet (in Analogie zu dem Freigabecode bei einem Autoradio). Weiters auch die Ortung per GPS oder Mobilfunknetz.

Weiters kann auf der Leiterplatte (10) eine Kontroll-LED angeordnet sein, die die korrekte Funktion visuell signalisiert beziehungsweise Funktionsprobleme über eine voreingestellte Impulsfolge beziehungsweise Leuchtimpulsfrequenz signalisiert und derart eine kontaktlose Funktionsabfrage ermöglicht.

Weiters kann auf der Leiterplatte (10) eine Temperaturanzeige angeordnet sein und es kann dadurch die aktuelle Temperatur abgelesen werden. Ferner kann eine RFID Einrichtung auf der Leiterplatte (10) angeordnet sein und dadurch kann eine Fernabfrage diverser Funktionsmerkmale erfolgen. Zusätzlich kann ein Diebstahlschutzsystem aktiviert werden.

Der Solarmodulanschluß (19) erfolgt von der Leiterplatte (10) mittels Aussparung (19) durch das rückseitige Substrat (7) oder an den Modulrändern seitlich, indem die elektrischen Verbindungsleitungen am Modulrand in eine Steckverbindung geführt werden und derart, dass die elektrischen Verbindungsleitungen in die Anschlußbox (Junctionbox) geführt werden.

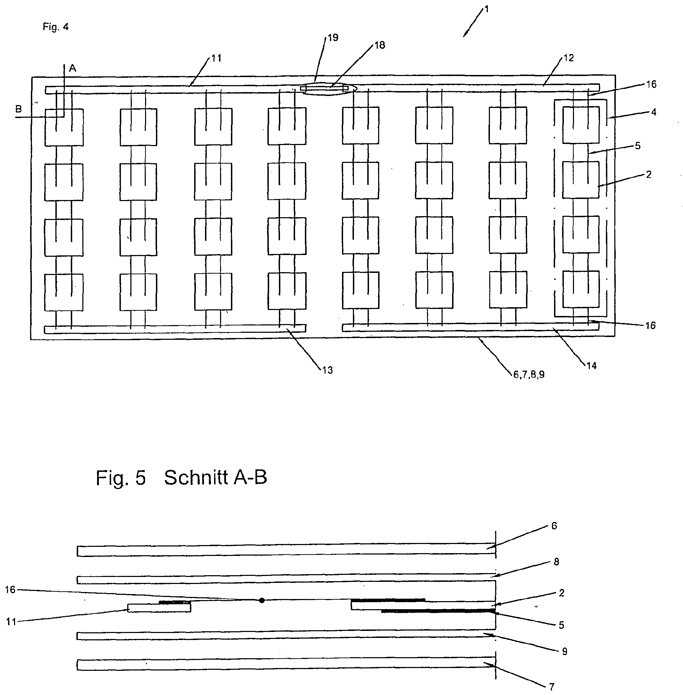

In **Figur 4** wird eine schematische Draufsicht auf ein Solarmodul (1) mit vier Leiterplatten (11, 12, 13, 14) dargestellt. Solche Leiterplatten (11, 12, 13, 14) werden weltweit mit Standarformaten im Mehrfachnutzen hergestellt. Dabei sind Abmessungen von 610 mm bis maximal 760 mm die gegenwärtig größtmögliche Länge. Die Erfindung ist jedoch nicht auf eine solche Größenabmessung beschränkt.

Falls größere Solarmodul (1) Formate mit Leiterplatten (11, 12, 13, 14) verdrahtet werden sollen, bietet sich die Stückelung mehrere einzelner Leiterplatten (11, 12, 13, 14) mittels Verbindungen (18) an. Derartige Verbindungen (18) können als einfache Drahtverbindungen oder Steckverbindungen ausgeführt werden.

Neben der geradlinigen Ausbildung der Leiterplatten (11, 12, 13, 14) können abgewinkelte oder U-förmige Leiterplatten verwendet werden. Es können auch flexible Leiterplatten (FPCs: Flexible Printed Circuit's) mit längeren Abmessungen verwendet werden, wobei üblicherweise die Kosten dafür etwas höher anzusetzen sind, als bei starren und gestückelten Leiterplatten.

In dieser Ausführungsform werden acht Solarzellenketten (4) mit jeweils vier in Serie geschalteten Zellen (2) mit den Leiterplatten (11, 12, 13, 14) verbunden. Die Beschaltung mit Bypassdioden oder anderen Regelelektronikkomponenten kann sehr einfach und anwendungsspezifisch auf den Leiterplatten (11, 12, 13, 14) realisiert werden.

In **Figur 5** wird ein schematischer Schnitt durch ein Solarmodullaminat (6, 8, 5, 2, 9, 7) mit einer Leiterplatte (11) dargestellt.

In dieser Darstellung kann sehr gut erkannt werden, dass die Leiterplatte (11) in einer Ebene mit der Zelle (2) angeordnet ist. Übliche Solarzellen (2) weisen Dicken von etwa 150 µm bis 220 µm, typisch 180 µm auf mit der Tendenz zu dünneren Dicken und damit der Kostensparung. Zusätzlich zu der Zellendicke kommen noch die beidseitig angeordneten Kontaktleitungen (5, 16) und damit werden Dicken von etwa 0,3 bis 0,5 mm erreicht. Eine typische Leiterplatte (11) weist in einer dünnen Ausführungsform eine Dicke von 0,5 mm bis 0,8 mm auf und kann unter Umständen kostengünstiger beziehungsweise mit einer höheren Steifigkeit mit einer Dicke von 1,2 mm beziehungsweise 1,5 bis 1,6 mm ausgeführt werden.

Da die beiden Laminatfolien (8, 9) eine Dicke von typisch 0,37 mm aufweisen, ist ersichtlich, dass bei Verwendung einer rückseitigen Laminatverbundfolie (7) nahezu alle Dicken verarbeitet werden können, dass jedoch bei Verwendung eines rückseitigen Glases (7) eine geringe Dicke von zum Beispiel 0,5 mm ein Vorteil sein wird. Da die Leiterplatte (11) üblicherweise nur ein wenige Millimeter breiter Streifen sein wird, bleibt neben der Leiterplatte (11) genügend Materialverdrängungsplatz, um eine gute Lamination zu erreichen.

Ein bevorzugtes Herstellungsverfahren für Solarmodule (1) nach der Erfindung besteht aus mehreren, auf einem elektrisch isolierenden Trägerkörper (3) angeordneten einzelnen, kristallinen Solarzellen (2) mit je einem elektrisch gegeneinander isolierten Front- und einem Rückkontakt (7, 6).
Entsprechend der Solarmodulverschaltung werden die Strings (5) über Leiterbahnabschnitte (4a, 4b) auf dem Trägerkörper (3) elektrisch miteinander verbunden, wobei der elektrische Kontakt zwischen dem Rückkontakt (6) der Solarzellen und den Leiterbahnabschnitten (4a) über Verbindungen aus elektrisch hochleitfähigem Leitkleber hergestellt ist.

Hierbei werden folgende Verfahrensschritte durchgeführt:
- Montage jeder einzelnen (1/19) kristallinen Solarzelle (2) mittels eines Aufnahme-, Transport und Ablege-Verfahrens (Pick-and-Place), das auf ein Trägermedium für eine Vielzahl von einzelnen, kristallinen Solarzellen (2) zugreift, auf den mit Leiterbahnabschnitten (4a, 4b) vorbereiteten Trägerkörper (3) des Solarmoduls (3),
- Aufbringen und Aushärten einer im Randbereich jeder kristallinen Solarzelle (2) angeordneten, wallartig begrenzten Isolationsschicht (11) zwischen Front-und Rückkontakt (7, 6) jeder kristallinen Solarzelle (2),
- Dispensen oder Aufdrucken von Leitkleberpads (9) auf den Trägerkörper (3) zwischen dem Rand der Solarzellen (2) und den zu kontaktierenden

Leiterbahnabschnitten (4b) und • Dispensen von Leitkleber in Form zumindest einer gezogenen Leitkleberbrücke (12) zwischen dem Frontkontakt (7) jeder kristallinen Solarzelle (2) und einem zugeordneten Leiterbahnabschnitt (4b) im Bereich der Isolationsschicht (11) zum Kontaktieren des Frontkontaktes (7).

In einer bevorzugten Weiterbildung erfolgt das Dispensen von Leitkleber zur Herstellung der Leiterbahnabschnitte (4a, 4b) auf dem Trägerkörper (3) zumindest im Bereich der Rückkontakte (6) der zu kontaktierenden Einzelnen, kristallinen Solarzellen (2).

Nach einer Weiterbildung erfolgt das Dispensen der Isolationsschicht (11) in Form von Isolationslack.

Nach einer Weiterbildung erfolgt das Dispensen oder Aufdrucken einer Isoliermasse in Form eines geschlossen umlaufenden Damms (10) auf den Trägerkörper (3) im Randbereich jeder kristallinen Solarzelle (2) oder im gesamten Randbereich des Solarmoduls (1).

Nach einer Weiterbildung erfolgt das Beschichten des kontaktierten Solarmoduls (1) im Bereich der Frontkontakte (7) mit einer elektrisch isolierenden Masse (13).

Nach einer Weiterbildung erfolgt das Beschichten des kontaktierten Solarmoduls (1) auf der Vorderseite mit einer elektrisch isolierenden Masse (13).

Nach einer Weiterbildung erfolgt die Anordnung zusätzlicher elektronischer Bauelemente zur Erfüllung anderer Funktionen als die der Stromerzeugung mittels Pick-and-Place-Verfahren von einem Trägermedium auf den mit Leiterbahnabschnitten vorbereiteten Trägerkörper des Solarmoduls und mit einer Kontaktierung der elektronischen Bauelemente durch zusätzliches Löten oder Kleben.

Vorteilhaft besteht das Solarmodul (1) aus mehreren, auf einem elektrisch isolierenden Trägerkörper (3) angeordneten einzelnen, kristallinen Solarzellen (2) mit je einem elektrischen Frontkontakt (7) und einem Rückkontakt (6), die gegeneinander isoliert sind.

Die einzelnen, kristallinen Solarzellen (2) sind entsprechend der Solarmodulverschaltung über Leiterbahnabschnitte (4a, 4b) auf dem Trägerkörper (3) elektrisch miteinander verbunden, wobei der elektrische Kontakt zwischen dem Rückkontakt (6) der Solarzellen und den Leiterbahnabschnitten (4a) über Verbindungen aus elektrisch hochleitfähigem Leitkleber hergestellt ist.

Wichtig ist, dass zwischen dem Frontkontakt (7) der einzelnen, kristallinen Solarzellen (2) und dem zugeordneten Leiterbahnabschnitt (4b) zumindest eine ungeträgerte Leitkleberbrücke (12) aus elektrisch hochleitfähigem Leitkleber gebildet ist, die auf einer im Randbereich der einzelnen, kristallinen Solarzelle (2) angeordneten, wallartig begrenzten und scharfe Kanten vermeidenden Isolationsschicht (11) zwischen Front-und Rückkontakt (7, 6) der Solarzelle (2) aufliegt.

Der Trägerkörper (3) weist zwischen dem Rand der einzelnen, kristallinen Solarzellen (2) und den zugeordneten Leiterbahnabschnitten (4b) gedruckte oder dispenste Leitkleberpads (9) auf.

Die einzelnen, kristallinen Solarzellen (2)sind in zwei Reihen mit jeweils außen liegenden Frontkontakten (7) In Form von Stromschienen und einem minimalen Abstand zueinander angeordnet.

Der Trägerkörper (3) weist im Randbereich jeder kristallinen Solarzelle (2) oder im Randbereich des Solarmoduls (1) einen geschlossen umlaufenden Damm (10) aus einer elektrisch isolierenden Masse auf. Das Solarmodul (1) ist im Bereich der Frontkontakte (7) mit einer elektrisch isolierenden Masse beschichtet.

Das Solarmodul (1) ist auf der gesamten Vorderseite mit einer elektrisch isolierenden Vergussmasse (13) beschichtet.

Die wallartig begrenzte Isolationsschicht (11) ist im Randbereich jeder kristallinen Solarzelle (2) aus einem Isolationslack gebildet

Die Front- und Rückkontakte (7, 6) der einzelnen, kristallinen Solarzellen (2) bestehen aus einem beliebigen, insbesondere nicht-lötfähigen, aber elektrisch gut leitenden Material.

Es sind zusätzliche elektronische Bauelemente zur Erfüllung anderer Funktionen als die der Stromerzeugung auf der Leiterplatte angeordnet und kontaktiert.

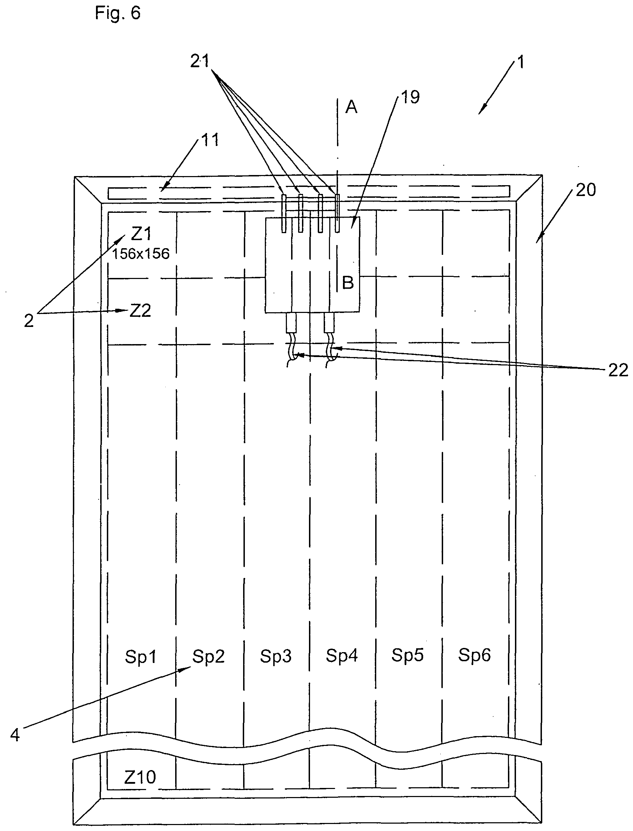

Die Figur 6 zeigt die Draufsicht auf ein Solarmodul 1 mit insgesamt 60 zeilen- und spaltenweise angeordneten Solarzellen 2. Jede Zelle hat beispielsweise eine Abmessung von 156 x 156 mm, sodass sich insgesamt eine Größe von 990 x 1620 mm ergibt.

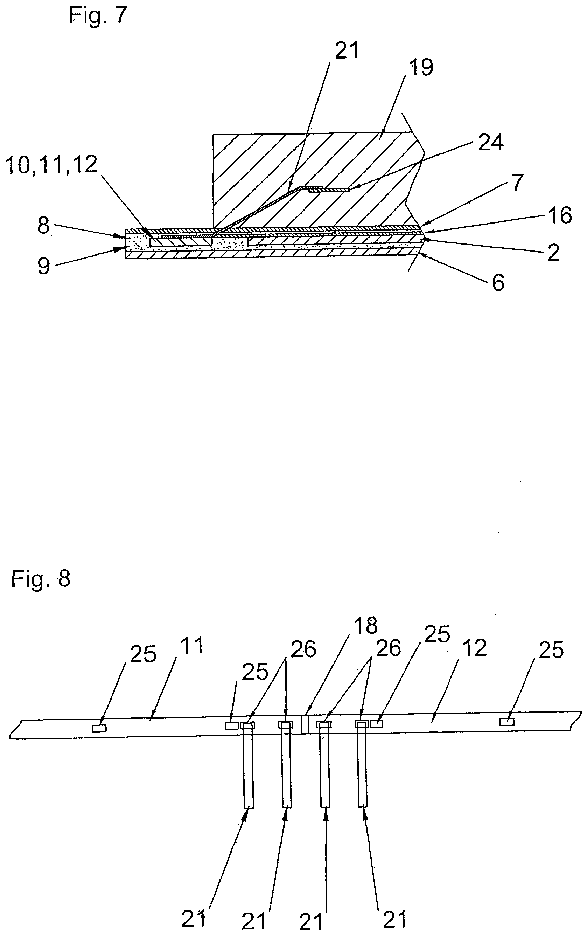

Es ist mit rechteckigen Linien eine auf dem Solarmodul 1 oberhalb einer Solarzelle 2 angeordnete Anschluss-Box 19 (siehe auch Figur 7) dargestellt. Die Verbindungen der Anschluss-Box zur Leiterplatte sind mit 22 bezeichnet. Ferner zeigt die Figur 6, dass das gesamte Solarmodul 1 von einem Modul-Rahmen 20 umgeben ist.

Von der Anschluss-Box 19 führen externe Anschlussleitungen 22 nach außen.

In Figur 7 sind die Einzelheiten der Integration der Anschluss-Box 19 auf der Rückseite des Solarmoduls 1 oberhalb einer Solarzelle 2 dargestellt. Die elektrische Verbindung 16 zwischen der Solarzelle 2 und der Leiterplatte 11 führt auf die Oberseite der Leiterplatte 12, während von der Oberseite der Leiterplatte 12 die elektrische Verbindung 21 zur Anschluss-Box 19 auf den Kontakt 24 wegführt. Die Figur 7 zeigt deutlich die geringe Dicke der Leiterplatte 12, die somit günstig in den Laminatverbund 8, 9 zwischen den front- und rückseitigen Laminaten oder Gläsern 6, 7 integriert werden kann.

Die Figur 8 zeigt eine Draufsicht auf die Leiterplatten 11, 12 mit der Verbindung 18 mit lötfähigen Anschlusspunkten 25, 26, auf denen parallele Strings 16, 21 angelötet sind.

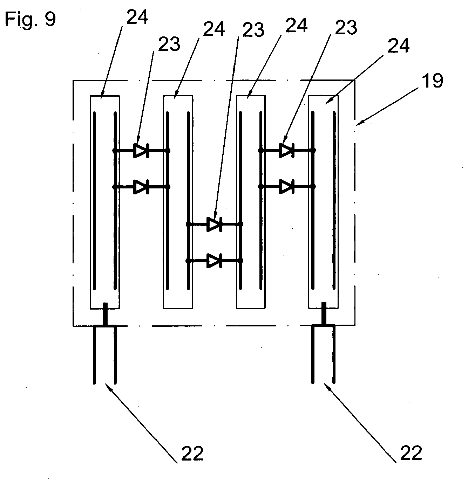

Figur 9 zeigt die Leitungsführung 24 in der Anschluß-Box 19 mit einer Serien-Parallelschaltung von Bypassdioden 23, die somit getrennt angesteuert werden können und wahlweise ein oder mehrere Solarzellenketten 4 aus dem elektrischen Verbund des Solarmoduls 1 gegen Fehlstrom schützen können, sofern eine oder mehrere Solarzellen 2 einer Solarzellenkette 4 abgeschattet oder elektrisch beschädigt sind. Die Anschluß-Box 19 weist elektrische Anschlüsse 22 auf.

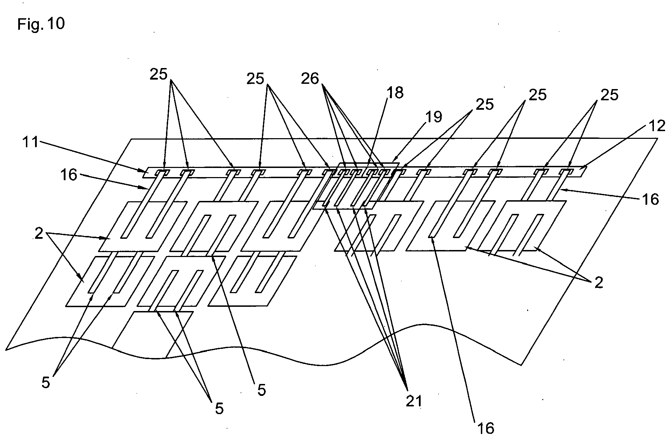

Figur 10 zeigt eine schematische Darstellung des oberen Bereichs eines Solarmoduls 1 auf. Dabei ist die Position der Anschluß-Box 19 schematisch in den Umrissen eingezeichnet. Die Leiterplatten 11, 12 weisen Anschlußflächen 25 zur Kontaktierung der Strings 16 von den diversen Solarzellen 2 auf, und es sind beispielhaft vier Kontaktstellen 26 vorgesehen, auf die Strings 21 kontaktiert werden, die wiederum die elektrische Verbindung zur Anschluß-Box 19 bewirken. Die Strings 16 kommen wahlweise von den Oberseiten oder Unterseiten der Solarzellen 2 und werden bevorzugt auf der Oberseite der Leiterplatten 11, 12 kontaktiert.

### Zeichnungslegende

- 1: Solarmodul beziehungsweise Photovoltaikmodul
- 2: Solarzelle beziehungsweise Photovoltaikzelle
- 3: Einzelzelle
- 4: Solarzellenkette beziehungsweise in Serie geschaltete Zellen
- 5: String beziehungsweise elektrisch leitendes Verbindungselement
- 6: Frontscheibe beziehungsweise vordere Glasscheibe
- 7: Rückseitiges Substrat beziehungsweise rückseitiges Folienlaminat beziehungsweise auch rückseitiges Glas, rückseitige transparente oder nicht transparente Kunststoff-Folie, rückseitige Metallfolie, rückseitige Kunststoff-Platte, rückseitige Metallplatte
- 8: Verbundfolie frontseitig: EVA, PVB, EVM, Silikon
- 9: Verbundfolie rückseitig: EVA, PVB, EVM, Silikon
- 10: Leiterplatte
- 11: Leiterplatte links oben
- 12: Leiterplatte rechts oben
- 13: Leiterplatte links unten
- 14: Leiterplatte rechts unten
- 15: Verbindungs-String von einer Solarzellenkette zu einer zweiten
- 16: Verbindung Solarzelle zur Leiterplatte
- 17: Sonne
- 18: Verbindung von zwei Leiterplatten
- 19: Anschluß des Solarmoduls (Anschluss-Box / Junction-Box)
- 20: Modul-Rahmen
- 21: Verbindung Leiterplatte zu Anschluss-Box
- 22: Anschlüsse der Anschluss-Box
- 23: Bypassdiode
- 24: Verdrahtung in Anschluß-Box: Blechbiege-Stanzteil oder Leiterplatte
- 25: Kontaktflächen auf der Leiterplatte für die Verbindung zu den Solarzellen
- 26: Kontaktflächen auf der Leiterplatte für die Verbindung zu der Anschluß-Box

## Patentansprüche

1. Solarmodul (1) bestehend aus einer Mehrzahl von Solarzellenketten (4), die wiederum aus einer Mehrzahl von in Serie geschalteten Solarzellen (2) bestehen, wobei die Solarzellenketten (4) in Serie und/oder parallel geschaltet und mittels Haftverbundfolien (8, 9) zwischen einem vorderseitigen Glassubstrat (6) und einer rückseitigen Folie (7) beziehungsweise einem rückseitigen Glassubstrat (7) einlaminiert sind, wobei die Verdrahtung (16) von zumindest den Solarzellenketten (4) über eine Leiterplatte (10, 11, 12, 13, 14) erfolgt, die Modul-randseitig oder mittig im Laminatverbund (6, 8, 2, 5, 16, 9, 7) angeordnet ist, und von dieser Leiterplatte (10, 11, 12, 13, 14) rückseitig oder seitlich durch eine Aussparung in der rückseitigen Folie (7) oder dem rückseitigen Glassubstrat (7) ein Anschluss an eine Anschluß-Box (19) erfolgt, **dadurch gekennzeichnet, dass** die Leiterplatte (10, 11, 12, 13, 14) in der Ebene der Solarzellen (2) im Laminatverbund (6, 8, 2, 5, 16, 9, 7) angeordnet ist, und auf der Leiterplatte (10, 11, 12, 13, 14) diverse elektronische Komponenten, insbesondere Bypassdioden (23), Schaltelemente oder MPP-Tracking Bauelemente angeordnet und mit den Solarzellen (2) verschaltet sind, wobei die Leiterplatte (10, 11, 12, 13, 14) lötfähige Anschlusspunkte (25, 26) aufweist, auf denen parallele Strings (16, 21) als bandförmige Verbindungsleiter zu den Solarzellen (2) und der Anschluss-Box (19) des Solarmoduls angelötet sind.

2. Solarmodul (1) nach Anspruch 1, **dadurch gekennzeichnet, dass** die Solarzellen (2) kristalline oder multikristalline oder amorphe oder organische Solarzellen sind oder starre oder flexible Solarzellen sind oder allgemein Dünnfilm-Solarzellen sind oder Solarzellen aus partikulären halbleitenden Partikeln oder rückseitenkontaktierte Solarzellen.

3. Solarmodul (1) nach Anspruch 1 oder 2, **dadurch gekennzeichnet, dass** die Leiterplatte (10) nur an einer Seite angeordnet ist oder mehrere Leiterplatten (11, 12, 13, 14) oben und unten oder an jeder Seite eine Leiterplatte (10) oder mehrere Leiterplatten (10) angeordnet sind oder die Leiterplatten (11, 12, 13, 14) abgewinkelt ausgeführt sind.

4. Solarmodul (1) nach einem der Ansprüche 1 bis 3, **dadurch gekennzeichnet, dass** der Anschluß an die Anschluss-Box (19) von einer Leiterplatte (10, 11, 12, 13, 14) mittels Aussparung durch das rückseitige oder seitlich am Modulrand befindliche Substrat (7) erfolgt, und derart die Strings (21) in die Anschluß-Box (19) oder einen Stecker geführt werden.

5. Solarmodul (1) nach einem der Ansprüche 1 bis 4, **dadurch gekennzeichnet, dass** auf der Leiterplatte (10, 11, 12, 13, 14) diverse elektronische Bauteile angeordnet und derart ausgebildet sind, dass das Problem der Abschattung oder des Defektes oder der Leistungsminderung einer oder mehrerer Einzelzellen (3) oder Zellen (2) durch elektronische Maßnahmen derart gelöst wird, dass das Solarmodul (1) immer im MPP (Maximum Power Point), also im maximalen Leistungsbereich betrieben wird, und derart auf der Leiterplatte ein integriertes MPP Tracking gegeben ist und derart einzelne Zellen abschaltbar sind.

6. Solarmodul (1) nach einem der Ansprüche 1 bis 5, **dadurch gekennzeichnet, dass** die Leiterplatte (10, 11, 12, 13, 14) eine beliebig farbige Oberfläche aufweist, insbesondere eine weiße Oberfläche aufweist, und dabei die Lötstopmaske mit weißer Farbe ausgebildet ist.

7. Solarmodul (1) nach einem der Ansprüche 1 bis 6, **dadurch gekennzeichnet, dass** die Leiterplatte (10, 11, 12, 13, 14) als einseitige oder durchkontaktierte Leiterplatte oder Mehrlagenleiterplatte ausgebildet ist.

8. Solarmodul (1) nach einem der Ansprüche 1 bis 7, **dadurch gekennzeichnet, dass** auf der Leiterplatte (10, 11, 12, 13, 14) eine visuell und/oder maschinell lesbare Information vorhanden ist, insbesondere ein Barcode, eine Herstellerangabe, eine Typenangabe, eine Produktionsdatumsangabe beziehungsweise diverse Logos und Zulassungskennzeichnungen.

9. Solarmodul (1) nach einem der Ansprüche 1 bis 8, **dadurch gekennzeichnet, dass** die Elektronik auf der Leiterplatte (10, 11, 12, 13, 14) eine Diebstahlsicherung aufweist und insbesondere einen Code zur Freigabe des Solarmoduls (1) beinhaltet, oder ein Ortungssystem mittels GPS oder Mobilfunknetz beinhaltet.

10. Solarmodul (1)nach einem der Ansprüche 1 bis 9, **dadurch gekennzeichnet, dass** auf der Leiterplatte (10, 11, 12, 13, 14) eine Kontroll-LED angeordnet ist, die die richtige Funktion visuell signalisiert oder Funktionsprobleme über eine voreingestellte Impulsfolge beziehungsweise Leuchtimpulsfrequenz signalisiert, und derart eine kontaktlose Funktionsabfrage ermöglicht.

11. Solarmodul (1) nach einem der Ansprüche 1 bis 10, **dadurch gekennzeichnet, dass** sämtliche Solarzellen (2) direkt mit der Leiterplatte (10, 11, 12, 13, 14) verbunden sind.

12. Solarmodul (1) nach einem der Ansprüche 1 bis 11, **dadurch gekennzeichnet, dass** die Leiterplatte (10, 11, 12, 13, 14) einfach oder mehrfach gewinkelt ausgebildet ist.

13. Solarmodul (1) nach einem der Ansprüche 1 bis 12, **dadurch gekennzeichnet, dass** auf der Leiterplatte (10, 11, 12, 13, 14) eine Temperaturanzeige angeordnet ist.

14. Solarmodul (1) nach einem der Ansprüche 1 bis 13, **dadurch gekennzeichnet, dass** auf der Leiterplatte (10, 11, 12, 13, 14) eine RFID Einrichtung integriert ist, die zur Fernabfrage diverser Funktionsmerkmale und zur Aktivierung eines Diebstahlschutzsystems ausgebildet ist.

15. Solarmodul (1) nach einem der Ansprüche 1 bis 13, **dadurch gekennzeichnet, dass** auf der Leiterplatte ein Stecksystem integriert ist, welches zum Aufstecken von Anschlussdosen oder elektronischen Geräten ausgebildet ist.

16. Solarmodul (1) nach einem der Ansprüche 1 bis 14, **dadurch gekennzeichnet, dass** auf der Leiterplatte (10, 11, 12, 13, 14) die Anschlußkontakte auf beiden Seiten in Kupfer-Lötzinn oder in Kupfer-Nickel-Gold oder in Kupfer-Silber ausgebildet sind, und derart Strings (5) beziehungsweise Anschlußelemente (16, 17) mittels Löten oder Ultraschall oder Laser-induziert kontaktierbar sind.

17. Verfahren zur Herstellung eines Solarmoduls (1) nach einem der Ansprüche 1 bis 16, wobei die Leiterplatte (10, 11, 12, 13, 14) mit den Solarzellen (2) beziehungsweise den Solarzellenketten (4) elektrisch verbunden werden und auf der Ebene der Solarzellen (2) mittels Haftverbundfolien (8, 9) zwischen einem vorderseitigen Glassubstrat (6) und einer rückseitigen Folie (7) beziehungsweise einem rückseitigen Glassubstrat (7) mit einer Laminiervorrichtung zusammenlaminiert werden, und der Anschluß rückseitig mit direkten Kontakten (19) zur Leiterplatte (10, 11, 12) erfolgt, **dadurch gekennzeichnet,**
**dass** die Leiterplatte (10, 11, 12, 13, 14) in der Ebene der Solarzellen (2) im Laminatverbund (6, 8, 2, 5, 16, 9, 7) angeordnet wird, und
**dass** auf der Leiterplatte (10, 11, 12, 13, 14) diverse elektronische Komponenten, insbesondere Bypassdioden (23), Schaltelemente oder MPP-Tracking Bauelemente angeordnet und mit den Solarzellen (2) verschaltet werden, wobei die Leiterplatte (10, 11, 12, 13, 14) mit lötfähigen Anschlusspunkten (25, 26) versehen wird, auf denen parallele Strings (16, 21) als bandförmige Verbindungsleiter zu den Solarzellen (2) und einer Anschluß-Box (19) angelötet werden.

18. Anwendung eines Solarzellenmoduls (1) hergestellt nach dem Verfahren 17 zur direkten Konvertierung von Sonnenenergie in elektrische Energie.

## Claims

1. Solar module (1) consisting of a plurality of chains of solar cells (4), which in turn consist of a plurality of series-connected solar cells (2), wherein the chains of solar cells (4) are connected in series and/or in parallel and laminated by means of adhesive films (8, 9) between a glass substrate (6) on the front side and a foil (7) on the rear side or a glass substrate (7) on the rear side, wherein the wiring (16) of at least the chains of solar cells (4) is effected via a circuit board (10, 11, 12, 13, 14) which is arranged at the edge of the module or centrally in the laminate (6, 8, 2, 5, 16, 9, 7), and from this circuit board (10, 11, 12, 13, 14) on the rear side or laterally through a recess in the foil (7) on the rear side or the glass substrate (7) on the rear side a connection is made to a junction box (19), **characterised in that** the circuit board (10, 11, 12, 13, 14) is arranged in the plane of the solar cells (2) in the laminate (6, 8, 2, 5, 16, 9, 7), and on the circuit board (10, 11, 12, 13, 14) various electronic components, in particular bypass diodes (23), switching elements or MPP tracking components, are arranged and connected to the solar cells (2), wherein the circuit board (10, 11, 12, 13, 14) has solderable terminals (25, 26) to which parallel strings (16, 21) as strip-like connecting cables to the solar cells (2) and the junction box (19) of the solar module are soldered.

2. Solar module (1) according to claim 1, **characterised in that** the solar cells (2) are crystalline or multicrystalline or amorphous or organic solar cells or are rigid or flexible solar cells or generally thin-film solar cells or solar cells consisting of individual semiconducting particles or rear-side contact solar cells.

3. Solar module (1) according to claim 1 or 2, **characterised in that** the circuit board (10) is arranged on one side only or a plurality of circuit boards (11, 12, 13, 14) are arranged at the top and bottom or one circuit board (10) or a plurality of circuit boards (10) are arranged on each side or the circuit boards (11, 12, 13, 14) are angled.

4. Solar module (1) according to one of claims 1 to 3, **characterised in that** the connection to the junction box (19) from a circuit board (10, 11, 12, 13, 14) is made by means of a recess through the substrate (7) located on the rear side or laterally at the edge of the module, and in this way the strings (21) lead into the junction box (19) or a connector.

5. Solar module (1) according to one of claims 1 to 4, **characterised in that** on the circuit board (10, 11, 12, 13, 14) various electronic components are arranged and designed in such a way that the problem of shading or malfunction or reduced output of one or more individual cells (3) or cells (2) is solved by electronic measures in such a way that the solar module (1) is always operated at MPP (maximum power point), therefore within the maximum range of capacity, and in this way integrated MPP tracking is provided on the circuit board and in this way individual cells can be switched off.

6. Solar module (1) according to one of claims 1 to 5, **characterised in that** the circuit board (10, 11, 12, 13, 14) has a surface of any desired colour, in particular a white surface, and in this case the solder resist mask is designed with a white colour.

7. Solar module (1) according to one of claims 1 to 6, **characterised in that** the circuit board (10, 11, 12, 13, 14) is designed as a single-sided or plated-through circuit board or multilayer circuit board.

8. Solar module (1) according to one of claims 1 to 7, **characterised in that** on the circuit board (10, 11, 12, 13, 14) there is visual and/or machine-readable information, in particular a bar code, a manufacturer's specification, a model specification, a date of manufacture or various logos and approval marks.

9. Solar module (1) according to one of claims 1 to 8, **characterised in that** the electronics on the circuit board (10, 11, 12, 13, 14) have an antitheft device and in particular include a code for clearance of the solar module (1), or a position finding system using GPS or mobile phone network.

10. Solar module (1) according to one of claims 1 to 9, **characterised in that** on the circuit board (10, 11, 12, 13, 14) is arranged a pilot LED which visually signals correct function or signals function problems via a preset pulse sequence or light pulse frequency, and thus allows contactless function monitoring.

11. Solar module (1) according to one of claims 1 to 10, **characterised in that** all of the solar cells (2) are directly connected to the circuit board (10, 11, 12, 13, 14).

12. Solar module (1) according to one of claims 1 to 11, **characterised in that** the circuit board (10, 11, 12, 13, 14) is angled one or more times.

13. Solar module (1) according to one of claims 1 to 12, **characterised in that** on the circuit board (10, 11, 12, 13, 14) is arranged a temperature display.

14. Solar module (1) according to one of claims 1 to 13, **characterised in that** an RFID device which is designed for the remote retrieval of various function features and for activation of an antitheft protection system is integrated on the circuit board (10, 11, 12, 13, 14).

15. Solar module (1) according to one of claims 1 to 13, **characterised in that** a connection system which is designed for plugging in sockets or electronic devices is integrated on the circuit board.

16. Solar module (1) according to one of claims 1 to 14, **characterised in that** on the circuit board (10, 11, 12, 13, 14) the terminal contacts on both sides are designed in copper-tin solder or in copper-nickel-gold or in copper-silver, and thus strings (5) or terminal elements (16, 17) can be contacted by soldering or ultrasound or laser-induced.

17. Method for the manufacture of a solar module (1) according to one of claims 1 to 16, wherein the circuit board (10, 11, 12, 13, 14) is electrically connected to the solar cells (2) or the chains of solar cells (4) and in the plane of the solar cells (2) laminated together with a laminating device by means of adhesive films (8, 9) between a glass substrate (6) on the front side and a foil (7) on the rear side or a glass substrate (7) on the rear side, and the connection is made on the rear side with direct contacts (19) to the circuit board (10, 11, 12), **characterised in that** the circuit board (10, 11, 12, 13, 14) is arranged in the plane of the solar cells (2) in the laminate (6, 8, 2, 5, 16, 9, 7), and **in that** on the circuit board (10, 11, 12, 13, 14) various electronic components, in particular bypass diodes (23), switching elements or MPP tracking components, are arranged and connected to the solar cells (2), wherein the circuit board (10, 11, 12, 13, 14) is provided with solderable terminals (25, 26) to which parallel strings (16, 21) as strip-like connecting cables to the solar cells (2) and a junction box (19) are soldered.

18. Use of a solar cell module (1) manufactured by the method of claim 17 for the direct conversion of solar energy to electrical energy.

## Revendications

1. Module solaire (1) composé de plusieurs chaînes de cellules solaires (4) qui se composent elles-mêmes de plusieurs cellules solaires (2) montées en série, les chaînes de cellules solaires (4) étant montées en série et/ou en parallèle et placées par stratification entre un substrat en verre côté avant (6) et une feuille côté arrière (7) ou un substrat en verre côté arrière (7), à l'aide de feuilles composites adhésives (8, 9), le câblage (16) d'au moins les chaînes de cellules solaires (4) se faisant par l'intermédiaire d'une carte imprimée (10, 11, 12, 13, 14) qui est disposée du côté du bord du module ou de manière centrale dans le stratifié composite (6, 8, 2, 5, 16, 9, 7), et cette carte imprimée (10, 11, 12, 13, 14) réalisant, du côté arrière ou latéralement grâce à un creux dans la feuille côté arrière (7), un raccordement à un boîtier de raccordement (19), **caractérisé en ce que** la carte imprimée (10, 11, 12, 13, 14) est disposée dans le plan des cellules solaires (2) dans le stratifié composite (6, 8, 2, 5, 16, 9, 7), et sur la carte imprimée (10, 11, 12, 13, 14) divers composants électroniques, en particulier des diodes de dérivation (23), des éléments de commutation ou des régulateurs MPPT sont disposés et raccordés aux cellules solaires (2), la carte imprimée (10, 11, 12, 13, 14) présentant des points de raccordement (25, 26) aptes à être soudés sur lesquels sont soudées des bandes parallèles (16, 21) comme conducteurs de raccordement avec les cellules solaires (2) et avec le boîtier de raccordement (19) du module solaire.

2. Module solaire (1) selon la revendication 1, **caractérisé en ce que** les cellules solaires (2) sont des cellules solaires cristallines ou polycristallines ou amorphes ou organiques ou des cellules solaires rigides ou flexibles ou d'une manière générale des cellules solaires à couches minces ou des cellules solaires composées de particules semi-conductrices particulaires ou des cellules solaires à connexion sur le côté arrière.

3. Module solaire (1) selon la revendication 1 ou 2, **caractérisé en ce que** la carte imprimée (10) est disposée sur un seul côté, ou plusieurs cartes imprimées (11, 12, 13, 14) sont disposées en haut et en bas, ou une carte imprimée (10) ou plusieurs cartes imprimées (10) sont disposées de chaque côté, ou les cartes imprimées (11, 12, 13, 14) sont coudées.

4. Module solaire (1) selon l'une des revendications 1 à 3, **caractérisé en ce que** le raccordement au boîtier de raccordement (19) est réalisé par une carte imprimée (10, 11, 12, 13, 14), à l'aide d'un creux dans le substrat (7) qui se trouve sur le côté arrière ou latéralement au bord du module, et les bandes (21) sont ainsi amenées dans le boîtier de raccordement (9) ou dans un connecteur.

5. Module solaire (1) selon l'une des revendications 1 à 4, **caractérisé en ce que** divers composants électroniques sont disposés sur la carte imprimée (10, 11, 12, 13, 14) et sont conçus de telle sorte que le problème de l'effet d'ombre ou du défaut ou de la réduction de puissance d'une ou plusieurs cellules individuelles (3) ou cellules (2) soit résolu par des mesures électroniques, **en ce que** le module solaire (1) fonctionne toujours dans la zone MPP (Maximum Power Point), c'est-à-dire dans la zone de puissance maximale, et il y a ainsi toujours une régulation MPP intégrée, et des cellules individuelles peuvent ainsi être arrêtées.

6. Module solaire (1) selon l'une des revendications 1 à 5, **caractérisé en ce que** la carte imprimée (10, 11, 12, 13, 14) présente une surface d'une couleur quelconque, en particulier une surface blanche, et la réserve de soudure est formée avec une couleur blanche.

7. Module solaire (1) selon l'une des revendications 1 à 6, **caractérisé en ce que** la carte imprimée (10, 11, 12, 13, 14) est conçue comme une carte imprimée unilatérale ou à connexion transversale ou comme une carte imprimée multicouche.

8. Module solaire (1) selon l'une des revendications 1 à 7, **caractérisé en ce qu'**il est prévu sur la carte imprimée (10, 11, 12, 13, 14) une information apte à être lue visuellement et/ou par machine, en particulier un code-barres, une indication de fabricant, une indication de type, une indication de date de production ou divers logos et identifications d'autorisation.

9. Module solaire (1) selon l'une des revendications 1 à 8, **caractérisé en ce que** le système électronique présente sur la carte imprimée (10, 11, 12, 13, 14) un dispositif antivol et contient en particulier un code de mise en service du module solaire (1), ou contient un système de localisation par GPS ou par réseau de téléphonie mobile.

10. Module solaire (1) selon l'une des revendications 1 à 9, **caractérisé en ce qu'**il est prévu sur la carte imprimée (10, 11, 12, 13, 14) une LED de contrôle qui signale visuellement le fonctionnement correct ou qui signale des problèmes de fonctionnement par l'intermédiaire d'une succession d'impulsions préréglée ou d'une fréquence d'impulsions et permet ainsi une interrogation de fonctionnement sans contact.

11. Module solaire (1) selon l'une des revendications 1 à 10, **caractérisé en ce que** toutes les cellules solaires (2) sont reliées directement à la carte imprimée (10, 11, 12, 13, 14).

12. Module solaire (1) selon l'une des revendications 1 à 11, **caractérisé en ce que** la carte imprimée (10, 11, 12, 13, 14) présente une forme coudée simple ou multiple.

13. Module solaire (1) selon l'une des revendications 1 à 12, **caractérisé en ce qu'**il est prévu sur la carte imprimée (10, 11, 12, 13, 14) un indicateur de température.

14. Module solaire (1) selon l'une des revendications 1 à 13, **caractérisé en ce qu'**il est prévu, intégré sur la carte imprimée (10, 11, 12, 13, 14), un dispositif RFID qui est conçu pour l'interrogation à distance de diverses caractéristiques de fonctionnement et pour l'activation d'un système antivol.

15. Module solaire (1) selon l'une des revendications 1 à 13, **caractérisé en ce qu'**il prévu, intégré sur la carte imprimée, un système de branchement qui permet le branchement de boîtes de raccordement ou d'appareils électroniques.

16. Module solaire (1) selon l'une des revendications 1 à 14, **caractérisé en ce que** sur la carte imprimée (10, 11, 12, 13, 14), les contacts de raccordement sont formés sur les deux côtés avec une soudure cuivre-étain ou cuivre-nickel-or ou cuivre-argent, et les bandes (5) ou éléments de raccordement (16, 17) sont aptes à être montés par soudure ou ultrasons ou induction laser.

17. Procédé pour fabriquer un module solaire (1) selon l'une des revendications 1 à 16, **caractérisé en ce que** la carte imprimée (10, 11, 12, 13, 14) est disposée dans le plan des cellules solaires (2) dans le stratifié composite (6, 8, 2, 5, 16, 9, 7), et **en ce que** sur la carte imprimée (10, 11, 12, 13, 14) divers composants électroniques, en particulier des diodes de dérivation (23), des éléments de commutation ou des régulateurs MPPT sont disposés et raccordés aux cellules solaires (2), la carte imprimée (10, 11, 12, 13, 14) étant pourvue de points de raccordement (25, 26) aptes à être soudés sur lesquels sont soudées des bandes parallèles (16, 21) comme conducteurs de raccordement avec les cellules solaires (2) et avec un boîtier de raccordement (19) du module solaire.

18. Application d'un module de cellules solaires (1) fabriqué selon le procédé 17, pour une conversion directe d'énergie solaire en énergie électrique.
